(19) Europäisches Patentamt

European Patent Office

Office européen des brevets

(11) **EP 3 136 496 B1**

(12) **EUROPEAN PATENT SPECIFICATION**

(45) Date of publication and mention
of the grant of the patent:
**03.07.2019 Bulletin 2019/27**

(21) Application number: **15791936.6**

(22) Date of filing: **14.05.2015**

(51) Int Cl.:
***H01M 10/63*** (2014.01)          ***H01M 10/633*** (2014.01)
***H01M 10/48*** (2006.01)

(86) International application number:
**PCT/KR2015/004862**

(87) International publication number:
**WO 2015/174766 (19.11.2015 Gazette 2015/46)**

(54) **BATTERY COOLING SYSTEM SIMULATION DEVICE AND METHOD**

BATTERIEKÜHLSYSTEMSIMULATIONSVORRICHTUNG UND -VERFAHREN

DISPOSITIF ET PROCÉDÉ DE SIMULATION DE SYSTÈME DE REFROIDISSEMENT DE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **16.05.2014 KR 20140058995**

(43) Date of publication of application:
**01.03.2017 Bulletin 2017/09**

(73) Proprietor: **LG CHEM, LTD.**
**Yeongdeungpo-gu**
**Seoul 07336 (KR)**

(72) Inventors:
• **CHOI, Yong-Seok**
**Daejeon 34122 (KR)**
• **KANG, Dal-Mo**
**Daejeon 34122 (KR)**
• **JUNG, Seung-Hun**
**Daejeon 34122 (KR)**
• **NAM, Jin-Moo**
**Daejeon 34122 (KR)**

(74) Representative: **Cabinet Plasseraud**
**66, rue de la Chaussée d'Antin**
**75440 Paris Cedex 09 (FR)**

(56) References cited:
**JP-A- 2007 157 348       JP-A- 2008 041 509
US-A1- 2007 120 537     US-A1- 2011 229 749**

• **PARK HEESUNG: "A design of air flow
configuration for cooling lithium ion battery in
hybrid electric vehicles", JOURNAL OF POWER
SOURCES, ELSEVIER SA, CH, vol. 239, 27 March
2013 (2013-03-27), pages 30-36, XP028566928,
ISSN: 0378-7753, DOI:
10.1016/J.JPOWSOUR.2013.03.102**
• **CONG ZHU ET AL: "Development of a
theoretically based thermal model for lithium ion
battery pack", JOURNAL OF POWER SOURCES,
vol. 223, 1 February 2013 (2013-02-01), pages
155-164, XP055236330, CH ISSN: 0378-7753, DOI:
10.1016/j.jpowsour.2012.09.035**
• **ZHU, CONG ET AL.: 'Development of a
theoretically based thermal model for lithium ion
battery pack' JOURNAL OF POWER SOURCES
vol. 223, 2013, ISSN 0378-7753 pages 155 - 164,
XP055236330**
• **PARK, HEESUNG: 'A design of air flow
configuration for cooling lithium ion battery in
hybrid electric vehicles' JOURNAL OF POWER
SOURCES vol. 239, 2013, ISSN 0378-7753 pages
30 - 36, XP028566928**

**Description**

TECHNICAL FIELD

The present disclosure relates to battery cooling system simulation, and more particularly, to a battery cooling system simulation device and method for predicting thermal response of a battery cell through simulation, or calculating a design parameter satisfying a target thermal response of a battery cell through simulation.

The present application claims priority to Korean Patent Application No. 10-2014-0058995 filed in the Republic of Korea on May 16, 2014.

BACKGROUND ART

Due to their high applicability to various products and electrical properties such as a high energy density, secondary batteries are not only commonly applied to portable devices, but universally applied to electric vehicle (EV) or hybrid vehicle (HV) that drive on an electric driving source.

Secondary batteries are gaining attention for their primary advantage of remarkably reducing the use of fossil fuels and not generating by-products from the use of energy, making them a new eco-friendly and energy efficient source of energy.

A battery pack used in electric vehicle includes a plurality of battery units, each battery unit including a plurality of unit cells, wherein the unit cell can be charged and discharged repeatedly by electrochemical reactions between components including a positive current collector, a separator, an active material, an electrolyte solution, and an aluminum thin film layer.

In addition to this basic structure for charging and discharging, the battery pack further includes a mechanical protection device, various sensing means, and firmware to which a precise algorithm for estimation of a state of charge (SOC) is applied.

The battery pack comprising an assembly of various chemical elements and electrical and mechanical elements is intrinsically affected by the outside environment in which it is used. Thus, the battery pack may drastically change in electrochemical properties depending on the outside environment to which it is exposed, and as a consequence, the life, stability, or operating performance of the battery pack is greatly affected.

Particularly, process of charging or discharging the battery cell is accomplished by electrochemical reactions, so the battery cell is affected by the surrounding temperature condition environment, and for example, if a charging/discharging process is performed under the bad temperature condition such as high temperature at which optimal temperature is not maintained, the battery cell degrades, causing the charging/discharging efficiency to reduce, and accordingly, it may be difficult to guarantee the performance under normal operation.

In addition, in the battery pack including multiple battery cells, if a certain battery cell degrades, the performance of the entire battery pack may be limited by the performance of the certain degraded battery cell. Also, as the degraded cell increases in internal resistance, the temperature of the corresponding cell further increases and there is concern that performance degradation of the battery cell will be accelerated.

What is worse, in case that the temperature of the battery cell further increases, the battery cell may be at risk of overheating and exploding. This may become an incomparably serious problem to the performance degradation of the battery cell or the battery pack. That is, if the temperature of the battery cell is quite high, an electrolyte in the battery cell is evaporated, the internal pressure of the battery cell increases, gas inside the cell may be emitted, and in worse case, explosion may occur.

Accordingly, it is very important to maintain the battery cell at optimal temperature. However, the optimal temperature of the battery cell may change depending on detailed condition such as an object to which the battery cell is applied and the environment. Thus, there is the need to cool the battery cell properly depending on detailed condition such as an object to which the battery cell is applied and the environment.

Traditional cooling technology may be largely classified into water cooling and air cooling. It is obvious that water cooling and air cooling can be all used to cool the battery cell. However, in the respect that water cooling has a risk of short circuits, air cooling is being widely used to cool the battery cell. Particularly, a method which cools the battery cells provided in the battery pack by feeding cooling air through flow channels formed in the battery pack is being primarily used.

In the air cooling method, the temperature of the battery cell is mainly determined by the mass flow rate of cooling air fed through the flow channels and the size of the flow channel, so determining the mass flow rate of cooling air and the size of the flow channel is very important. Seeing from a different perspective, if the mass flow rate of cooling air and the size of the flow channel is determined, the temperature of the battery cell can be predicted. Through this, thermal conditions of the battery cell can be identified, and using the thermal conditions, the degree of degradation of the battery cell can be predicted.

However, according to earlier technology, to predict the temperature of a battery cell by using the mass flow rate of cooling air and the size of a flow channel, or on the contrary, to design the mass flow rate of cooling air and the size of a flow channel that allows target temperature of a battery cell to be satisfied, a very complex process needs to be performed. For example, battery pack designers can predict the temperature of a battery cell or calculate a value of design parameter such as the mass flow rate of cooling air and the size of a flow channel through simulation using Computational Fluid Dynamics (CFD) or experimental approach. An examples of such predictions that can be found in HEESUNG. A design of air flow configuration for cooling lithium ion battery in hybrid electrical vehicles. In: Journal of power sources, Elsevier SA, CH, vo. 239, 27 March 2013. Further example can be found for instance ZHU et, all. Development of a theoretically based thermal model for lithium ion battery pack. In: Journal of power sources, vol. 223, 1 February 2013. However, this simulation method requires a high performance computer because it goes through a very complex process, and even though a high performance computer is used, it takes a long time.

DISCLOSURE

Technical Problem

The present disclosure is designed to solve the problem such as the above, and therefore the present disclosure is directed to providing a battery cooling system simulation device and method for predicting thermal response of a battery cell by a simple method, or allowing the design of a battery cooling system satisfying target thermal response.

These and other objects and advantages of the present disclosure can be understood from the following detailed description and will become more fully apparent from the embodiments of the present disclosure. Also, it will be easily understood that the objects and advantages of the present disclosure may be realized by the means shown in the appended claims and combinations thereof

Technical Solution

To achieve the object, a battery cooling system simulation device as defined in the claims 1-4 is a battery cooling system simulation device that predicts thermal response to a battery cooling system using simulation, the battery cooling system in which cooling air coming in through an inlet goes through a at least one flow channel having an approximately rectangular parallelepiped shape having predetermined thickness a, length b and depth L and having an aspect ratio a/b of the flow channel such that the flow channel can be treated as parallel plate geometry and a wetted perimeter P of the flow channel can be approximated to 2b. The at least one flow channel formed along a side wall of at least one battery unit equipped with at least one battery cell and is discharged through an outlet to cool the battery unit, and the battery cooling system simulation device includes a first input unit which receives inputs of temperature information of the inlet and temperature information of the outlet, a second input unit which receives inputs of quantity of heat information generated from the battery cell, a design parameter input unit which receives inputs of dimension information of the flow channel and mass flow rate information of the cooling air, and a temperature prediction unit which predicts temperature of the battery cell by using the information inputted from the first input unit, the second input unit, and the design parameter input unit.

The dimension information of the flow channel include a length, a thickness, and a depth of the flow channel, and the temperature prediction unit predicts the temperature of the battery cell through the following equation:

$$m_{cell} C_{p,c} \frac{dT_{cell}}{dt} = q_{gen} - \dot{m}_a C_{p,a} \left( T_{cell} - T_{mi} \right) \left[ 1 - \exp\left( - \frac{PL}{\dot{m}_a C_{p,a}} \overline{h} \right) \right]$$

where

$$\overline{h} = \frac{k_a \overline{Nu_T}}{D_h},$$

$$\overline{Nu}_T = 7.55 + \frac{0.024 L_*^{-1.14}}{1 + 0.0358 \Pr^{0.17} L_*^{-0.64}},$$

$$L_* = \frac{L}{D_h \operatorname{Re} \Pr},$$

$$D_h = \frac{4ab}{P} \approx 2a,$$

$$\operatorname{Re} = \frac{\dot{m}_a D_h}{\mu(ab)},$$ mcell denotes mass of battery cell, Cp,a denotes specific heat capacity of cooling air, Cp,c denotes specific heat capacity of battery cell, Tcell denotes temperature of battery cell, Qgen denotes quantity of heat generated from battery cell, $\dot{m}_\alpha$ denotes mass flow rate of cooling air passing through each channel, Tmi denotes temperature of inlet, Tmo denotes temperature of outlet, P denotes wetted perimeter of flow channel, a denotes thickness of flow channel, b denotes length of flow channel, L denotes depth of flow channel, $\overline{h}$ denote convective heat transfer coefficient, ka denotes thermal conductivity of cooling air, $\overline{Nu}_T$ denotes Nusselt number averaged over L, L* denotes dimensionless length of flow channel, Pr denotes Prandtl number, Dh denotes hydraulic diameter, Re denotes Reynolds number and μ denotes dynamic viscosity of cooling air.

Also, the temperature prediction unit predicts the temperature of the battery cell through equation approximated as below:

$$\frac{T_{cell} - T_{mi}}{q_{gen}} = \left[ \dot{m}_a C_{p,a} \left( 1 - \exp\left( -\frac{PL}{\dot{m}_a C_{p,a}} \overline{h} \right) \right) \right]^{-1}.$$

Also, the temperature prediction unit predicts the temperature of the battery cell through equation approximated as below:

$$\frac{T_{cell} - T_{mi}}{q_{gen}} = \left[ \dot{m}_a C_{p,a} \left( 1 - \exp\left( -\frac{PLk_a}{\dot{m}_a C_{p,a} D_h} 7.55 \right) \right) \right]^{-1}.$$

The battery cooling system simulation device further includes an information storage unit which stores at least one piece of constant or coefficient information.

To achieve the object, a battery cooling system simulation device according to claims 5-10 is a battery cooling system simulation device that calculates a design parameter of a battery cooling system using simulation, the battery cooling system in which cooling air coming in through an inlet goes through a at least one flow channel having an approximately rectangular parallelepiped shape having predetermined thickness a, length b and depth L and having an aspect ratio a/b of the flow channel such that the flow channel can be treated as parallel plate geometry and a wetted perimeter P of the flow channel can be approximated to 2b. The at least one flow channel formed along a side wall of at least one battery unit equipped with at least one battery cell and is discharged through an outlet to cool the battery unit, and the battery cooling system simulation device includes a first input unit which receives inputs of temperature information of the inlet and temperature information of the outlet, a second input unit which receives inputs of quantity of heat information generated from the battery cell, a temperature input unit which receives inputs of target temperature information, and a design parameter calculation unit which calculates a design parameter allowing the temperature of the battery cell to satisfy the target temperature by using the information inputted from the first input unit, the second input unit, and the temperature input unit.

The design parameter is a dimension of the flow channel and a mass flow rate of the cooling air.

The dimension of the flow channel includes a thickness, a length, and a depth of the flow channel.

The design parameter calculation unit calculates the design parameter through the following equation:

$$m_{cell} C_{p,c} \frac{dT_{cell}}{dt} = q_{gen} - \dot{m}_a C_{p,a} \left( T_{cell} - T_{mi} \right) \left[ 1 - \exp\left( -\frac{PL}{\dot{m}_a C_{p,a}} \overline{h} \right) \right]$$

where

$$\overline{h} = \frac{k_a \overline{Nu}_T}{D_h},$$

$$\overline{Nu}_T = 7.55 + \frac{0.024 L_*^{-1.14}}{1 + 0.0358 \mathrm{Pr}^{0.17} L_*^{-0.64}},$$

$$L_* = \frac{L}{D_h \mathrm{Re} \mathrm{Pr}},$$

$$D_h = \frac{4ab}{P} \approx 2a,$$

$$\mathrm{Re} = \frac{\dot{m}_a D_h}{\mu(ab)}$$

, mcell denotes mass of battery cell, Cp,a denotes specific heat capacity of cooling air, Cp,c denotes specific heat capacity of battery cell, Tcell denotes temperature of battery cell, Qgen denotes quantity of heat generated from battery cell, $\dot{m}_\alpha$ denotes mass flow rate of cooling air passing through each channel, Tmi denotes temperature of inlet, Tmo denotes temperature of outlet, P denotes wetted perimeter of flow channel, a denotes thickness of flow channel, b denotes length of flow channel, L denotes depth of flow channel, $\overline{h}$ denote convective heat transfer coefficient, ka denotes thermal conductivity of cooling air, $\overline{Nu}_T$ denotes Nusselt number averaged over L, L* denotes dimensionless length of flow channel, Pr denotes Prandtl number, Dh denotes hydraulic diameter, Re denotes Reynolds number and μ denotes dynamic viscosity of cooling air.

Also, the design parameter calculation unit calculates the design parameter through equation approximated as below:

$$\frac{T_{cell} - T_{mi}}{q_{gen}} = \left[ \dot{m}_a C_{p,a} \left( 1 - \exp\left( -\frac{PL}{\dot{m}_a C_{p,a}} \overline{h} \right) \right) \right]^{-1}$$

.

Also, the design parameter calculation unit calculates the design parameter through equation approximated as below:

$$\frac{T_{cell} - T_{mi}}{q_{gen}} = \left[ \dot{m}_a C_{p,a} \left( 1 - \exp\left( -\frac{PLk_a}{\dot{m}_a C_{p,a} D_h} 7.55 \right) \right) \right]^{-1}$$

.

The battery cooling system simulation device further includes an information storage unit which stores at least one piece of constant or coefficient information.

To achieve the object, a battery cooling system simulation method according to claim 11 is a battery cooling system simulation method that predicts thermal response to a battery cooling system using simulation, the battery cooling system in which cooling air coming in through an inlet goes through at least one flow channel having an approximately rectangular parallelepiped shape having predetermined thickness a, length b and depth L and having an aspect ratio a/b of the flow channel such that the flow channel can be treated as parallel plate geometry and a wetted perimeter P of the flow channel can be approximated to 2b, the at least one flow formed along a side wall of at least one battery unit equipped with at least one battery cell and is discharged through an outlet to cool the battery unit, and the battery cooling system simulation method includes a first input step for receiving inputs of temperature information of the inlet and temperature information of the outlet, a second input step for receiving inputs of quantity of heat information generated from the battery cell, a design parameter input step for receiving inputs of dimension information of the flow channel and mass flow rate information of the cooling air, and a temperature prediction step for predicting temperature of the battery cell by using the information inputted at the first input step, the second input step, and the design parameter input step.

The dimension information of the flow channel includes a length, a thickness, and a depth of the flow channel, and the temperature prediction step includes predicting the temperature of the battery cell through the following equation:

$$m_{cell} C_{p,c} \frac{dT_{cell}}{dt} = q_{gen} - \dot{m}_a C_{p,a} \left( T_{cell} - T_{mi} \right) \left[ 1 - \exp\left( -\frac{PL}{\dot{m}_a C_{p,a}} \overline{h} \right) \right]$$

where

$$\overline{h} = \frac{k_a \overline{Nu}_T}{D_h} \quad,$$

$$\overline{Nu}_T = 7.55 + \frac{0.024 L_*^{-1.14}}{1 + 0.0358 \mathrm{Pr}^{0.17} L_*^{-0.64}} \quad,$$

$$L_* = \frac{L}{D_h \mathrm{Re} \mathrm{Pr}} \quad,$$

$$D_h = \frac{4ab}{P} \approx 2a \quad,$$

$$\mathrm{Re} = \frac{\dot{m}_{a} D_{h}}{\mu(ab)}$$

' mcell denotes mass of battery cell, Cp,a denotes specific heat capacity of cooling air, Cp,c denotes specific heat capacity of battery cell, Tcell denotes temperature of battery cell, Qgen denotes quantity of heat generated from battery cell, $\dot{m}_{\alpha}$ denotes mass flow rate of cooling air passing through each channel, Tmi denotes temperature of inlet, Tmo denotes temperature of outlet, P denotes wetted perimeter of flow channel, a denotes thickness of flow channel, b denotes length of flow channel, L denotes depth of flow channel, $\bar{h}$ denote convective heat transfer coefficient, ka denotes thermal conductivity of cooling air, $\overline{Nu}_{T}$ denotes Nusselt number averaged over L, L* denotes dimensionless length of flow channel, Pr denotes Prandtl number, Dh denotes hydraulic diameter, Re denotes Reynolds number and $\mu$ denotes dynamic viscosity of cooling air.

Advantageous Effects

According to the present disclosure, thermal response of a battery cell can be predicted by solving a simple equation. Furthermore, according to the present disclosure, a design parameter satisfying target thermal response can be derived by solving a simple equation.

Particularly, according to the present disclosure, thermal response of a battery cell can be predicted or a design parameter satisfying target thermal response can be derived by solving a simple equation that can be derived by treating a flow channel having an approximately rectangular parallelepiped shape as a thin plate structure.

These and other effects of the present disclosure can be understood from the following detailed description and will become more fully apparent from the embodiments of the present disclosure. Also, it will be easily understood that the objects and advantages of the present disclosure may be realized by the means shown in the appended claims and combinations thereof.

BRIEF DESCRIPTION OF THE DRAWINGS

The accompanying drawing illustrates a preferred embodiment of the present disclosure and together with the foregoing disclosure, serves to provide further understanding of the technical spirit of the present disclosure, and thus, the present disclosure is not construed as being limited to the drawing.

FIG. 1 diagrammatically shows a battery cooling system according to an embodiment of the present disclosure.
FIG. 2 shows cross-section when viewed from the direction A of FIG. 1.
FIG. 3 diagrammatically shows a battery unit according to an embodiment of the present disclosure.
FIG. 4 shows the architecture of a battery cooling system simulation device according to an embodiment of the present disclosure.
FIG. 5 shows the architecture of a battery cooling system simulation device according to another embodiment of the present disclosure.
FIG. 6 diagrammatically shows a battery cooling system simulation method according to an embodiment of the present disclosure.
FIG. 7, not part of the invention, diagrammatically shows a battery cooling system simulation method according to another embodiment of the present disclosure.

MODE FOR CARRYING OUT THE INVENTION

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the embodiments described herein and illustrations shown in the drawings are just a most preferred embodiment of the present disclosure, and do not represent all the technical aspects of the present disclosure, so it should be understood that various alternative equivalents and variations could be made thereto at the time of filing the application.

Furthermore, in the description of the present disclosure, in case that a certain detailed description of related known configuration or functionality is deemed to render the nature of the present disclosure ambiguous, its detailed description is omitted herein.

Because the embodiments of the present disclosure are provided to offer a complete explanation of the present disclosure to those skilled in the art, the shape and size of elements in the drawings may be exaggerated or omitted or schematically illustrated for clarity. Thus, the size or proportion of each element does not entirely reflect the actual size or proportion.

Because a battery cooling system and a battery cooling system simulation device according to the present disclosure relate primarily to a battery system as a driving source of HEV or EV, a description is provided taking HEV or EV as an example, but the present disclosure is not limited thereto.

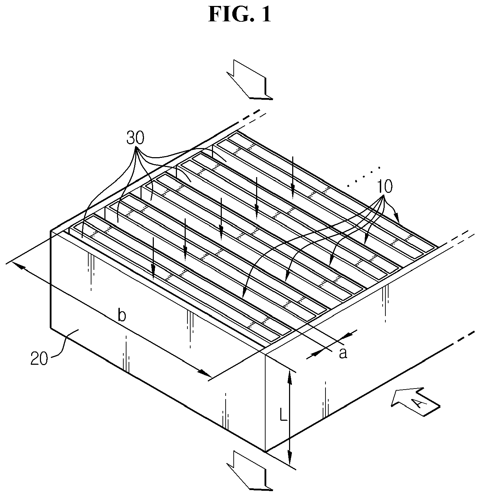

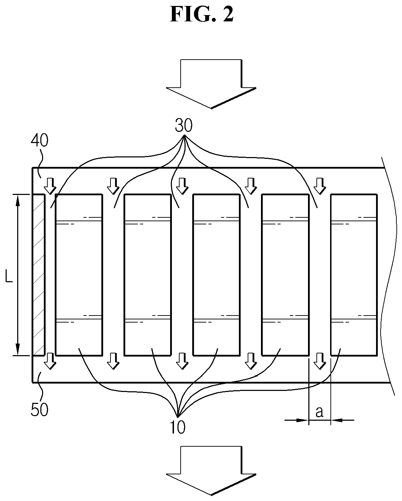

FIG. 1 diagrammatically shows a battery cooling system according to an embodiment of the present disclosure, and FIG. 2 shows cross section when viewed from the direction of A of FIG. 1.

Referring to FIGS. 1 and 2, the battery cooling system according to an embodiment of the present disclosure includes a battery unit 10, and a flow channel 30 is formed along the side wall of the battery unit 10.

Furthermore, the battery cooling system may include an inlet 40 through which cooling air flows in and an outlet 50 through which cooling air flows out. The cooling air flows in through the inlet 40 and flows out through the outlet 50 via the flow channel 30 formed along the side wall of the battery unit 10. Through this process, the battery unit 10 or a battery cell (BC) provided in the battery unit 10 is cooled and maintained at optimal temperature. On the other hand, although the inlet 40 and the outlet 50 are shown in FIG. 2, they are omitted in FIG. 1.

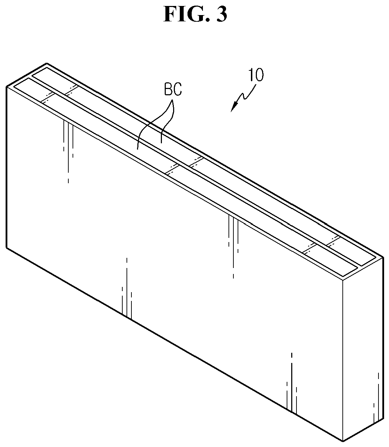

The battery cooling system may be provided with at least one battery unit 10. Also, the battery unit 10 may be provided with at least one battery cell (BC). That is, the battery system may include at least one battery unit 10, and the battery unit 10 may include at least one battery cell (BC). For example, the battery unit 10 may be a 2-cell unit consisting of two battery cells (BC) as shown in FIG. 3. In this instance, the 2-cell unit may be stacked in the form of a cartridge within a battery system. In this case, the flow channel 30 is formed, each one on each of the two side walls of the battery unit 10, so that one flow channel 30 is provided for each battery cell (BC). Here, the wall defined by the 2-cell unit corresponds to heating surface (heat transfer surface), and the area of heating surface per battery cell (BC) is given by L*b (see FIGS. 1 and 2).

In the battery cooling system, the battery unit 10 may be handled as a heating body. Also, heat generated from the battery cooling system is the sum of ohmic heat and electrochemical heat generated from the battery cell (BC) provided in the battery unit 10, and heat generated from the battery cell (BC) can be written as the following Equation.

【Equation 1】

$$q_{gen} = I^2 \cdot iR_{cell} + q_{electro-chem}$$

where I denotes the current flowing through the battery cell (BC), and iRcell denotes the direct current internal resistance of the battery cell (BC).

iRcell is a function of SOC, temperature (Tcell) of the battery cell (BC), charge/discharge status (CDS) and pulse duration $\tau$, and can be written as the following Equation.

【Equation 2】

$$iR_{cell}^t = iR_{cell}(CDS^t, \tau^t, SOC^{t-1}, T_{cell}^{t-1})$$

On the other hand, of the heat generated from the battery cell (BC), electrochemical heat is of low importance enough to neglect when compared to ohmic heat, and thus, only ohmic heat is taken into account. That is, the above Equation may be approximated as below.

【Equation 3】

$$q_{gen} = I^2 \cdot iR_{cell}$$

The flow channel 30 may provide an empty space having a predetermined dimension. For example, the flow channel 30 may provide a rectangular parallelopiped space having predetermined thickness (a), length (b) and depth (L). In this instance, the flow channel 30 has a rectangular shape, and preferably, a thin slit shape, when viewed from the upward or downward direction.

The flow channel 30 may be formed in multiple numbers. As at least one battery unit 10 may be provided, at least one flow channel 30 formed along the side wall of the battery unit 10 may be provided. When the cooling air flows in through the inlet 40, the cooling air is branched along at least one flow channel 30, and after cooling the battery unit 10, the cooling air is discharged through the outlet 50.

The battery cooling system according to the present disclosure is analyzed under the assumption that each flow channel 30 is identical. Thus, the mass flow rate $\dot{m}_\alpha$ of cooling air passing through the flow channel 30 can be calculated by dividing the total mass flow rate flowing in or out through the battery cooling system by the number of flow channels 30.

On the other hand, for heat transfer in the battery cooling system according to the present disclosure, only heat transfer by convection is taken into account.

A perfect heat transfer model should consider all the three heat transfer mechanisms, conduction, radiation and convection, but a heat transfer model may be simplified as a model considering only heat transfer by convection through appropriate assumption.

Referring back to FIGS. 1 and 2, after cooling air is fed in through the inlet 40 and then branched, the cooling air is discharged through the outlet 50 (U type flow). Also, heat transfer takes place by interaction between branched sub-streams and blocks defining the sub-stream channels 30. Here, the block defining the sub-stream channel 30 is a heating body, namely, the battery unit 10. In FIGS. 1 and 2, one battery unit 10 consists of two battery cells (BCs). Thus, one surface per battery cell (BC) is exposed to cooling air by convective heat transfer.

The block hardly comes into contact with a frame 20, and even if in contact with it, the quantity of heat transmitted from the battery unit 10 to outside by conduction through the frame 20 is neglectable, so conduction is not taken into account.

Also, assume that the flow channels 30 are a narrow passage through which cooling air flows, and the battery units 10 facing each other surrounding the flow channel 30 are heated by the battery units 10 facing them. In this environment, a view factor from the surface of the battery unit 10 to low outside temperature is neglectably small, and radiation to the battery unit 10 having a large view factor and radiation from the battery unit 10 having a large view factor is not important. It is because the temperature of the battery unit 10 is assumed to be almost equal. Thus, heat transfer by radiation may be also neglected.

Accordingly, for heat transfer in the battery cooling system according to the present disclosure, only heat transfer by convection may be taken into account. By this appropriate assumption, temperature prediction and design parameter calculation as described below can be achieved in a simple manner.

The battery cooling system simulation device according to the present disclosure is used to simulate thermal response to the aforementioned battery cooling system or design parameter.

Here, the thermal response to the battery cooling system refers to a state based on the temperature (Tcell) of the battery unit 10 or the battery cell (BC) provided in the battery unit 10 or changes in state. Thus, thermal response to the battery cooling system may primarily signify the temperature of the battery cell (BC) or changes in temperature.

Also, here, the design parameter for the battery cooling system includes information associated with the dimension of the flow channel 30 and the mass flow rate of cooling air that make the battery cell (BC) or the battery unit 10 to cool down to target temperature. Here, the information associated with the dimension of the flow channel 30 may be thickness (a), length (b), depth (L) or wetted perimeter (P) of the flow channel.

The information associated with the dimension of the flow channel 30 and the mass flow rate of cooling air is a key factor that cools the battery unit 10, and when this parameter is determined, the temperature of the battery unit 10 or the battery cell (BC) can be determined.

Accordingly, when the information associated with the dimension of the flow channel 30 and the mass flow rate information of cooling air is set, the temperature (Tcell) of the battery cell (BC) can be predicted and the thermal response of the battery cooling system can be predicted. On the contrary, when target temperature is set, the dimension of the flow channel 30 and the mass flow rate of cooling air that allows the target temperature to be satisfied can be determined. That is, the design parameter for the battery cooling system can be determined.

That is, the battery cooling system simulation device according to the present disclosure can be largely classified into simulation devices of two aspects.

First, the battery cooling system simulation device according to an aspect of the present disclosure is a device which predicts the temperature of battery cell provided in the battery cooling system by using the dimension information of flow channel and the mass flow rate of cooling air.

Next, the battery cooling system simulation device according to another aspect of the present disclosure is a device which calculates the dimension of flow channel and the mass flow rate of cooling air that allows target temperature to be satisfied when the target temperature of battery cell provided in the battery cooling system is set.

Hereinafter, a device for predicting the temperature of battery cell through simulation is first described, and a device for calculating design parameter through simulation is then described.

<Prediction of temperature of battery cell>

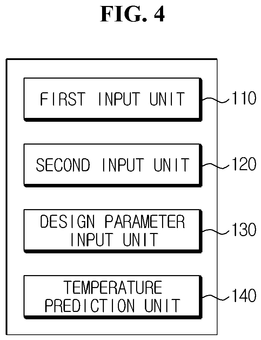

FIG. 4 shows the architecture of a battery cooling system simulation device according to an embodiment of the present disclosure.

Referring to FIG. 4, the battery cooling system simulation device according to an embodiment of the present disclosure includes a first input unit 110, a second input unit 120, a design parameter input unit 130 and a temperature prediction unit 140.

The first input unit 110 may receive inputs of temperature (Tmi) information of the inlet 40 and temperature (Tmo) information of the outlet 50.

The second input unit 120 may receive inputs of quantity of heat (Qgen) information generated from the battery cell (BC). In this instance, the second input unit 120 may directly receive inputs of the quantity of heat generated from the battery cell (BC), and receive inputs of information associated with I and iRcell. As described above, the quantity of heat (Qgen) generated from the battery cell (BC) is the sum of ohmic heat and electrochemical heat, and in this instance, the electrochemical heat is neglectable, so the quantity of heat generated from the battery cell (BC) can be calculated through I and iRcell.

The design parameter input unit 130 may receive inputs of dimension information of the flow channel 30, in particular, dimension information about the size of the flow channel 30, and mass flow rate information of cooling air. Here, the dimension information about the size of the flow channel 30 may include any one of thickness (a), length (b), and depth (L) of the flow channel 30 and wetted perimeter (P) information of the flow channel 30. Also, the mass flow rate information of cooling air is mass flow rate information of cooling air fed through the inlet 40 provided in the battery cooling system, and may be the total mass flow rate information flowing into the battery cooling system or mass flow rate information passing through the individual flow channel 30. In this instance, as the mass flow rate passing through the individual flow channel 30 may be regarded as being equal all over the flow channels 30, the total mass flow rate information flowing into the battery cooling system can be calculated by multiplying the mass flow rate passing through the individual flow channel 30 by the number of flow channels 30, and in contrast, mass flow rate information passing through the respective flow channel 30 can be calculated by dividing the total mass flow rate flowing into the battery cooling system by the number of flow channels 30.

The temperature prediction unit 140 may predict the temperature of the battery cell (BC) by using the information inputted from the first input unit 110, the second input unit 120 and the design parameter input unit 130. That is, the temperature prediction unit 140 may predict the temperature of the battery cell (BC) by using the dimension information about the size of the flow channel 30, the mass flow rate information of cooling air, the temperature information of the inlet 40, the temperature information of the outlet 50, and the quantity of heat information generated from the battery cell (BC).

More specifically, the temperature prediction unit 140 may predict the temperature of the battery cell (BC) by using the information inputted from the first input unit 110, the second input unit 120 and the design parameter input unit 130 and the following Equation. That is, the temperature prediction unit 140 may calculate Tcell by substituting the inputted information into the following Equation, and then solving a differential equation with respect to time.

【Equation 4】

$$m_{cell} C_{p,c} \frac{dT_{cell}}{dt} = q_{gen} - \dot{m}_a C_{p,a} \left( T_{cell} - T_{mi} \right) \left[ 1 - \exp\left( - \frac{PL}{\dot{m}_a C_{p,a}} \overline{h} \right) \right]$$

where

$$\overline{h} = \frac{k_a \overline{Nu}_T}{D_h}$$

$$\overline{Nu}_T = 7.55 + \frac{0.024 L_*^{-1.14}}{1 + 0.0358 \mathrm{Pr}^{0.17} L_*^{-0.64}}$$

$$L_* = \frac{L}{D_h \, \mathrm{Re} \, \mathrm{Pr}}$$

$$D_h = \frac{4ab}{P} \approx 2a$$

$$\mathrm{Re} = \frac{\dot{m}_\alpha D_h}{\mu(ab)}$$

where mcell denotes mass of the battery cell (BC), to be more concrete, mass of the unit battery cell (BC),

Cp,a denotes specific heat capacity of gas,

Cp,c denotes specific heat capacity of the battery cell (BC),

Tcell denotes temperature of the battery cell (BC),

Qgen denotes quantity of heat generated from the battery cell (BC),

$\dot{m}_\alpha$ denotes mass flow rate of cooling air passing through each channel,

Tmi denotes temperature of the inlet 40,

Tmo denotes temperature of the outlet 50,

P denotes wetted perimeter of the flow channel 30,

a denotes thickness of the flow channel 30,

b denotes length of the flow channel 30,

L denotes depth of the flow channel 30,

$\bar{h}$ denote convective heat transfer coefficient,

ka denotes thermal conductivity of air,

$\overline{Nu_T}$ denotes Nusselt number averaged over L,

L* denotes dimensionless length of the flow channel 30,

Pr denotes Prandtl number,

h denotes hydraulic diameter,

Re denotes Reynolds number,

μ denotes dynamic viscosity of cooling air.

The above Equation can be derived by the process such as below.
The quantity of heat accumulated at the battery cell (BC) is a value obtained by deducting the quantity of heat discharged to outside from the quantity of heat generated from the battery cell (BC). Also, according to the law of conservation of energy, the following Equation is established at the transient state.

【Equation 5】

$$m_{cell} C_{p,c} \frac{dT_{cell}}{dt} = q_{gen} - q_r$$

where mcell, Cp,c, Tcell and Qgen are the same as the above, and Qr is the quantity of heat discharged to outside.

As described in the foregoing, the battery cooling system according to the present disclosure only takes convective heat transfer into account, and heat transfer by conduction and radiation is neglectable, so Qr can be written by the following Equation.

【Equation 6】

$$q_r = \dot{m}_a C_{p,a} \left( T_{mo} - T_{mi} \right)$$

On the other hand, the battery cooling system according to the present disclosure is modeled by the Lumped thermal model, and the temperature gradient of the unit battery cell (BC) can be assumed to be relatively small, so the temperature of the unit battery cell (BC) can be used to represent the overall cell temperature. Also, referring to the prior art "Incropera,F.P., and Dewitt,D.P. Fundamentals of Heat and Mass Transfer. 4th Ed., John Wiley & Sons, 1996", the disclosure of which is incorporated herein, under the condition that the temperature on the battery cell (BC) surface which is the heat transfer surface is a constant value, Tmo may be written by Equation related to Tcell as below. Deriving this equation is obvious to those skilled in the art.

【Equation 7】

$$\frac{T_{cell} - T_{mo}}{T_{cell} - T_{mi}} = \exp\left( - \frac{PL}{\dot{m}_a C_{p,a}} \bar{h} \right)$$

Substituting the above Equations 6 and 7 into Equation 5, Equation 4 is derived.

$$m_{cell} C_{p,c} \frac{dT_{cell}}{dt} = q_{gen} - \dot{m}_a C_{p,a} \left( T_{cell} - T_{mi} \right) \left[ 1 - \exp\left( - \frac{PL}{\dot{m}_a C_{p,a}} \bar{h} \right) \right]$$

Integrating the above Equation 4 with respect to time, Tcell can be calculated. To calculate a solution of the differential equation, those skilled in the art would have used the heat transfer coefficient under various boundary conditions summarized in the prior art "Shah, R.K., and London, A.L. Laminar Flow Forced Convection in Ducts, Academic Press, 1978".

Also, here, $\bar{h}$ denotes a convective heat transfer coefficient, and can be written as below.

$$\bar{h} = \frac{k_a Nu_T}{D_h}$$

where ka denotes thermal conductivity of cooling air, $\overline{Nu}_T$ denotes Nusselt number averaged over L, and Dh denotes hydraulic diameter.

On the other hand, in the battery cooling system according to the present disclosure, an aspect ratio (a/b) of the flow channel 30 in square shape is sufficiently small. Thus, the flow channel 30 can be treated as parallel plate geometry. Accordingly, wetted perimeter (P) can be approximated to 2b. Also, as the wall defined by the battery unit 10 is under the temperature condition of a constant value, Nusselt number ($\overline{Nu}_T$ : Nusselt number averaged over L) at the parallel plate geometry can be written in closed form as below.

$$\overline{Nu}_T = 7.55 + \frac{0.024 L_*^{-1.14}}{1 + 0.0358 \, Pr^{0.17} \, L_*^{-0.64}}$$

where Pr denotes Prandtl number, and L* denotes dimensionless length of flow channel of the flow channel 30, and can be written as below.

$$L_* = \frac{L}{D_h \, Re \, Pr}$$

Here, Dh can be written as below. Also, as wetted perimeter (P) can be approximated to 2b as described above, Dh can be approximated as below.

$$D_h = \frac{4ab}{P} \approx 2a$$

The Re denotes Reynolds number, and can be written as below.

$$Re = \frac{\dot{m}_a D_h}{\mu(ab)}$$

where u denotes dynamic viscosity of cooling air.

Integrating Equation 4 with respect to time, Tcell can be calculated. Tcell calculated from the above Equation 4 corresponds to a predicted temperature value of the battery cell (BC).

On the other hand, in case that the temperature (Tcell) of the battery cell (BC) is irrespective of changes in time, namely, in case that the temperature (Tcell) of the battery cell (BC) does not change despite changes in time, the above Equation 4 can be further approximated. Thereby, Tcell can be only calculated by solving an algebraic equation rather than a differential equation. For example, in case that the battery cooling system is applied to Hybrid Electric vehicle (HEV), the temperature (Tcell) of the battery cell (BC) can be treated as being irrespective of changes in time. That is, preferably, the above Equation 4 can be approximated as below.

【Equation 8】

$$\frac{T_{cell} - T_{mi}}{q_{gen}} = \left[ \dot{m}_a C_{p,a} \left( 1 - \exp\left( -\frac{PL}{\dot{m}_a C_{p,a}} \overline{h} \right) \right) \right]^{-1}$$

Also, the above Equation 8 can be further approximated as below. In case that the thickness (a) of the flow channel 30 is sufficiently small, Nusselt number ($\overline{Nu}_T$ : Nusselt number averaged over L) can be treated as a constant value. That is, Nusselt number ($\overline{Nu}_T$ : Nusselt number averaged over L) of Equation 4 can be treated as a constant value of 7.55. Substituting 7.55 into Nusselt number of Equation 8, an Equation such as below is derived.

【Equation 9】

$$\frac{T_{cell} - T_{mi}}{q_{gen}} = \left[ \dot{m}_a C_{p,a} \left( 1 - \exp\left( -\frac{PLk_a}{\dot{m}_a C_{p,a} D_h} 7.55 \right) \right) \right]^{-1}$$

<Design parameter calculation of a battery cooling system>

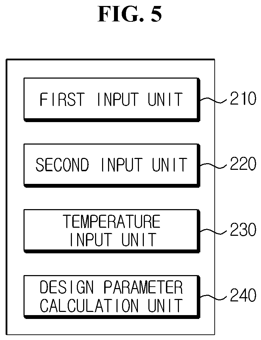

FIG. 5 shows the architecture of a battery cooling system simulation device according to another embodiment of the present disclosure.

Referring to FIG. 5, the battery cooling system simulation device according to another embodiment of the present disclosure includes a first input unit 210, a second input unit 220, a temperature input unit 230 and a design parameter calculation unit 240.

The first input unit 210 may receive inputs of temperature (Tmi) information of the inlet 40 and temperature (Tmo) information of the outlet 50, and the second input unit 220 may receive inputs of quantity of heat (Qgen) information generated from the battery cell (BC). In this instance, the second input unit 220 may directly receive inputs of the quantity of heat generated from the battery cell (BC), and may receive inputs of information associated with I and iRcell. As described above, the quantity of heat (Qgen) generated from the battery cell (BC) is the sum eof ohmic heat and electrochemical heat, and because the electrochemical heat is neglectable, the quantity of heat generated from the battery cell (BC) can be calculated through I and iRcell.

That is, the first input unit 210 and the second input unit 220 are the same as the element of the aforementioned battery cooling system simulation device according to an embodiment of the present disclosure (prediction of temperature of battery cell).

The temperature input unit 230 may receive inputs of target temperature information. Here, the target temperature information may refer to particular temperature and/or change amounts of temperature. The battery cooling system simulation device according to another embodiment of the present disclosure is a device which calculates a design parameter allowing the temperature of the battery cell (BC) to satisfy the target temperature, and calculates a design parameter satisfying the target temperature information inputted from the temperature input unit 230. Accordingly, the design parameter calculation unit 240 calculates a design parameter corresponding to the target temperature information inputted from the temperature input unit 230.

The design parameter calculation unit 240 may calculate a design parameter by using the information inputted from the first input unit 210, the second input unit 220 and the temperature input unit 230. That is, the design parameter calculation unit 240 may calculate a design parameter allowing the temperature of the battery cell (BC) to satisfy the target temperature by using the temperature information of the inlet 40, the temperature information of the outlet 50, the quantity of heat information generated from the battery cell (BC) and the target temperature information.

Here, the design parameter may be the dimension of the flow channel 30 and the mass flow rate of cooling air passing through the flow channel 30 which are key variables in determining the temperature of the battery cell (BC) by the battery cooling system, and more specifically, the dimension of the flow channel 30 may include thickness (a) of the flow channel 30, length (b) of the flow channel 30, and depth (L) of the flow channel 30.

More specifically, the design parameter calculation unit 240 may calculate a design parameter allowing the temperature of the battery cell (BC) to satisfy the target temperature and/or change amounts of the target temperature by using the information inputted from the first input unit 210, the second input unit 220 and the temperature input unit 230 and the following Equation (Equation 4 described above). That is, the design parameter calculation unit 240 may calculate a design parameter by substituting the inputted information into the following Equation, and then solving the following Equation.

$$m_{cell} C_{p,c} \frac{dT_{cell}}{dt} = q_{gen} - \dot{m}_a C_{p,a} \left( T_{cell} - T_{mi} \right) \left[ 1 - \exp\left( -\frac{PL}{\dot{m}_a C_{p,a}} \bar{h} \right) \right]$$

where

$$\overline{h} = \frac{k_a \overline{Nu}_T}{D_h}$$

$$\overline{Nu}_T = 7.55 + \frac{0.024 L_*^{-1.14}}{1 + 0.0358 \,\mathrm{Pr}^{0.17} L_*^{-0.64}}$$

$$L_* = \frac{L}{D_h \,\mathrm{Re}\,\mathrm{Pr}}$$

$$D_h = \frac{4ab}{P} \approx 2a$$

$$\mathrm{Re} = \frac{\dot{m}_a D_h}{\mu(ab)}$$

Preferably, the above Equation (Equation 4) can be approximated as shown in the following Equation (Equation 8).

$$\frac{T_{cell} - T_{mi}}{q_{gen}} = \left[ \dot{m}_a C_{p,a} \left( 1 - \exp\left( -\frac{PL}{\dot{m}_a C_{p,a}} \overline{h} \right) \right) \right]^{-1}$$

Furthermore, the above Equation (Equation 8) can be further approximated as shown in the following Equation (Equation 9).

$$\frac{T_{cell} - T_{mi}}{q_{gen}} = \left[ \dot{m}_a C_{p,a} \left( 1 - \exp\left( -\frac{PLk_a}{\dot{m}_a C_{p,a} D_h} 7.55 \right) \right) \right]^{-1}$$

The disclosure described in describing the battery cell temperature prediction may be applied to the above description of equation derivation process and approximation, and thus a repeated description is omitted herein. That is, because battery cell temperature prediction and calculation of design parameter satisfying the target temperature is seen from another aspect of substantially same technology, the description of battery cell temperature prediction may be applied to design parameter calculation.

On the other hand, preferably, the battery cooling system simulation device according to the present disclosure may further include an information storage unit. The information storage unit may store at least one piece of constant or coefficient information. Here, the constant or coefficient may be various constant or coefficient information used to predict the temperature of the battery cell (BC) and/or calculate the design parameter of the battery cooling system. More specifically, the information storage unit may store Cp, a, Cp, c, ka, Pr, $\mu$ used in the above Equation 4.

The temperature prediction unit 140 or the design parameter calculation unit 240 may predict the temperature of the battery cell (BC) or calculate the design parameter of the battery cooling system by using the constant or coefficient information stored in the information storage unit and the information inputted from the first input unit 110, 210 and the second input unit 210, 220.

Also, the temperature prediction unit 140 and/or the design parameter calculation unit 240 may selectively include processor, application-specific integrated circuit (ASIC), other chipset, logic circuit, register, communication modem, and data processing device that are known in the art to execute various control logics. Furthermore, when the above control logic is embodied as software, the temperature prediction unit 140 and/or the design parameter calculation unit 240 may be embodied as an assembly of program modules. In this instance, the program module may be stored in memory and executed by the processor. The memory may be inside or outside of the processor, and may be connected to the processor with a variety of known means. Furthermore, the memory may be included in the information storage unit of the present disclosure. Furthermore, the memory refers collectively to devices that store information regardless of the device type and does not indicate a particular memory device.

Also, it is obvious that the control logic of the temperature prediction unit 140 and/or the design parameter calculation unit 240 may implement a process of a battery cooling system simulation method according to the present disclosure as described later.

Also, the control logic of the temperature prediction unit 140 and/or the design parameter calculation unit 240 may be written in a computer-readable code and recorded in a computer-readable recording medium. The recording medium is not limited to a specific type if it is accessible by a processor included in a computer. As an example, the recording medium includes at least one selected from the group consisting of ROM, RAM, a register, CD-ROM, a magnetic tape, a hard disc, a floppy disc, and an optical data recording device. Also, the code may be modulated to a carrier signal and included in a communication carrier at a particular point in time, and may be distributed over network-coupled computer systems so that the code is stored and executed in a distributed fashion. Also, functional programs, codes, and code segments for implementing the combined control logics may be easily inferred by programmers in the technical field to which the present disclosure belongs.

The information storage unit stores programs needed for the temperature prediction unit 140 and/or the design parameter calculation unit 240 to execute the algorithm and data calculated while the algorithm is executed. The information storage unit is not limited to a particular type if it is a device which can store information such as DRAM, SRAM, ROM, EEPROM, Flash Memory, and Register.

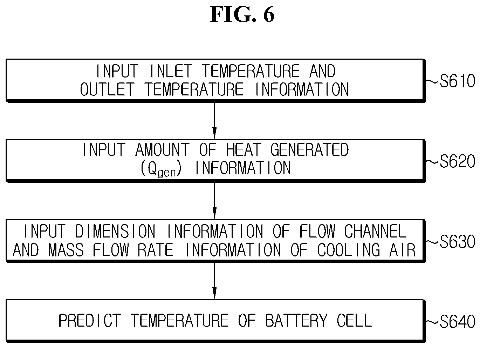

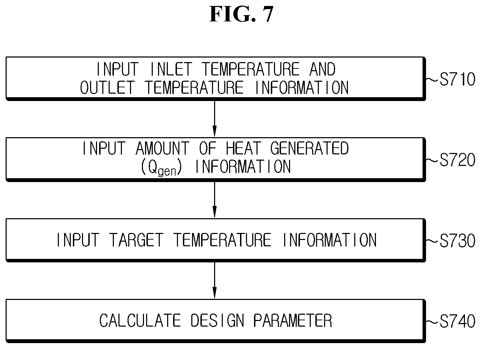

Hereinafter, a battery cooling system simulation method according to the present disclosure is described with reference to FIGS. 6 and 7. In FIGS. 6 and 7, the subject in each step is each component of the aforementioned battery cooling system simulation device, and thus overlapping description with the aforementioned disclosure is omitted herein.

<Prediction of temperature of battery cell>

FIG. 6 diagrammatically shows a battery cooling system simulation method according to an embodiment of the present disclosure.

Referring to FIG. 6, the battery cooling system simulation method according to an embodiment of the present disclosure is a method which predicts the temperature of the battery cell (BC) provided in the battery cooling system through simulation.

First, according to the method, inputs of temperature information of the inlet 40 and temperature information of the outlet 50 may be received (first input step, S610).

Subsequently, according to the method, inputs of quantity of heat information generated from the battery cell (BC) may be received (second input step, S620).

Subsequently, according to the method, inputs of dimension information of the flow channel 30 and mass flow rate information of cooling air may be received (design parameter input step, S630). Here, the dimension information of the flow channel 30 may include length (b) of the flow channel 30, thickness (a) of the flow channel 30, and depth (L) of the flow channel 30.

On the other hand, the first input step (S610), the second input step (S620) and the design parameter input step (S630) are not necessarily performed in the above order. That is, the first input step (S610), the second input step (S620) and the design parameter input step (S630) may be performed in a different order, and each step may be performed concurrently.

Subsequently, according to the method, the temperature of the battery cell (BC) may be predicted by using the information inputted from the first input step (S610), the second input step (S620) and the design parameter input step (S630) (temperature prediction step, S640).

Preferably, according to the method, the temperature of the battery cell (BC) may be predicted by using the information inputted from the first input step (S610), the second input step (S620) and the design parameter input step (S630) and the following Equation (Equation 4).

$$m_{cell} C_{p,c} \frac{dT_{cell}}{dt} = q_{gen} - \dot{m}_a C_{p,a} \left( T_{cell} - T_{mi} \right) \left[ 1 - \exp\left( - \frac{PL}{\dot{m}_a C_{p,a}} \bar{h} \right) \right]$$

where

$$\bar{h} = \frac{k_a \overline{Nu}_T}{D_h}$$

$$\overline{Nu}_T = 7.55 + \frac{0.024 L_*^{-1.14}}{1 + 0.0358 \Pr^{0.17} L_*^{-0.64}}$$

$$L_* = \frac{L}{D_h \operatorname{Re} \Pr}$$

$$D_h = \frac{4ab}{P} \approx 2a$$

$$\operatorname{Re} = \frac{\dot{m}_a D_h}{\mu(ab)}$$

Preferably, the above Equation (Equation 4) can be approximated as shown in the following Equation (Equation 8).

$$\frac{T_{cell} - T_{mi}}{q_{gen}} = \left[ \dot{m}_a C_{p,a} \left( 1 - \exp\left( -\frac{PL}{\dot{m}_a C_{p,a}} \bar{h} \right) \right) \right]^{-1}$$

Furthermore, the above Equation (Equation 8) can be further approximated as shown in the following Equation (Equation 9).

$$\frac{T_{cell} - T_{mi}}{q_{gen}} = \left[ \dot{m}_a C_{p,a} \left( 1 - \exp\left( -\frac{PL k_a}{\dot{m}_a C_{p,a} D_h} 7.55 \right) \right) \right]^{-1}$$

The disclosure described in describing the battery cooling system simulation device may be applied to the above description of equation derivation process and approximation, and thus a repeated description is omitted herein. That is, because the above method is described in the methodological aspect of the battery cooling system simulation device, the aforementioned description may be applied as it is.

In the description of various embodiments of the present disclosure, it should be understood that elements called '~ unit' are distinguished logically rather than physically. Accordingly, each element may be optionally integrated with other element or each element may be divided into sub-elements for efficient execution of control logic(s). However, even though elements are integrated or separated, it is obvious that integrated or separated elements shall be construed as falling within the scope of the present disclosure provided their function is considered as being identical.

**Claims**

1.   A battery cooling system simulation device that predicts temperature of a battery cell subjected to a battery cooling system using simulation, the battery cooling system in which cooling air coming in through an inlet (40) goes through at least one flow channel (30) having an approximately rectangular parallelepiped shape having predetermined thickness (a), length (b) and depth (L) and having an aspect ratio (a/b) of the flow channel such that the flow channel can be treated as parallel plate geometry and a wetted perimeter (P) of the flow channel can be approximated to 2b, the at least one flow channel formed along a side wall of at least one battery unit (10) equipped with at least one battery cell (BC) and is discharged through an outlet (50) to cool the battery unit, the battery cooling system simulation device comprising:

a first input unit (110) which receives inputs of temperature information (Tmi) of the inlet (40) and temperature information (Tmo) of the outlet (50);
a second input unit (120) which receives inputs of quantity of heat (Qgen) information generated from the battery cell (BC);
a design parameter input unit (130) which receives inputs of dimension information of the flow channel and mass flow rate information of the cooling air; and
a temperature prediction unit (140) which predicts temperature of the battery cell by using the information inputted from the first input unit, the second input unit, and the design parameter input unit,
wherein
the mass flow rate through the at least one flow channel (30) is calculated by dividing the total mass flow rate flowing in or out through the battery cooling system by the number of flow channels (30);
the second input unit (120) receives inputs of information associated with the current (I) flowing through the battery cell (BC) and direct current internal resistance (iRcell) of the battery cell (BC), wherein the quantity of heat (Qgen) generated from the battery cell (BC) is calculated as an ohmic heat through the current (I) and the direct current internal resistance (iRcell); the dimension information of the flow channel includes a length, a thickness, and a depth of the flow channel, and
the temperature prediction unit predicts the temperature of the battery cell through the following equation:

$$m_{cell}C_{p,c}\frac{dT_{cell}}{dt} = q_{gen} - \dot{m}_a C_{p,a}\left(T_{cell} - T_{mi}\right)\left[1 - \exp\left(-\frac{PL}{\dot{m}_a C_{p,a}}\overline{h}\right)\right]$$

where

$$\overline{h} = \frac{k_a \overline{Nu_T}}{D_h},$$

$$\overline{Nu_T} = 7.55 + \frac{0.024 L_*^{-1.14}}{1 + 0.0358 \Pr^{0.17} L_*^{-0.64}},$$

$$L_* = \frac{L}{D_h \operatorname{Re} \Pr},$$

$$D_h = \frac{4ab}{P} \approx 2a,$$

$$\mathrm{Re} = \frac{\dot{m}_a D_h}{\mu(ab)}$$

, mcell denotes mass of battery cell, Cp,a denotes specific heat capacity of cooling air, Cp, c denotes specific heat capacity of battery cell, Tcell denotes temperature of battery cell, Qgen denotes quantity of heat generated from battery cell, $\dot{m}_\alpha$ denotes mass flow rate of cooling air passing through each channel, Tmi denotes temperature of inlet, Tmo denotes temperature of outlet, P denotes wetted perimeter of flow channel, a denotes thickness of flow channel, b denotes length of flow channel, L denotes depth of flow channel, $\bar{h}$ denote convective heat transfer coefficient, ka denotes thermal conductivity of cooling air, $\overline{Nu}_T$ denotes Nusselt number averaged over L, L* denotes dimensionless length of flow channel, Pr denotes Prandtl number, Dh denotes hydraulic diameter, Re denotes Reynolds number and $\mu$ denotes dynamic viscosity of cooling air.

2.  The battery cooling system simulation device according to claim 1, wherein the temperature prediction unit predicts the temperature of the battery cell through equation approximated as below:

$$\frac{T_{cell} - T_{mi}}{q_{gen}} = \left[ \dot{m}_a C_{p,a} \left( 1 - \exp\left( -\frac{PL}{\dot{m}_a C_{p,a}} \bar{h} \right) \right) \right]^{-1}.$$

3.  The battery cooling system simulation device according to claim 1, wherein the temperature prediction unit predicts the temperature of the battery cell through equation approximated as below:

$$\frac{T_{cell} - T_{mi}}{q_{gen}} = \left[ \dot{m}_a C_{p,a} \left( 1 - \exp\left( -\frac{PLk_a}{\dot{m}_a C_{p,a} D_h} 7.55 \right) \right) \right]^{-1}.$$

4.  The battery cooling system simulation device according to any of claims 1 to 3, further comprising:
    an information storage unit which stores at least one piece of constant or coefficient information.

5.  A battery cooling system simulation device that calculates a design parameter of a battery cooling system using simulation, the battery cooling system in which cooling air coming in through an inlet (40) goes through at least one flow channel (30) having an approximately rectangular parallelepiped shape having predetermined thickness (a), length (b) and depth (L) and having an aspect ratio (a/b) of the flow channel such that the flow channel can be treated as parallel plate geometry and a wetted perimeter (P) of the flow channel can be approximated to 2b, the at least one flow channel formed along a side wall of at least one battery unit (10) equipped with at least one battery cell (BC) and is discharged through an outlet (50) to cool the battery unit, the battery cooling system simulation device comprising:

    a first input unit (210) which receives inputs of temperature information of the inlet and temperature information of the outlet;
    a second input unit (220) which receives inputs of quantity of heat (Qgen) information generated from the battery cell;
    a temperature input unit (230) which receives inputs of target temperature information; and
    a design parameter calculation unit (240) which calculates a design parameter allowing the temperature of the battery cell to satisfy the target temperature by using the information inputted from the first input unit, the second input unit, and the temperature input unit,
    wherein
    the mass flow rate through the at least one flow channel (30) is calculated by dividing the total mass flow rate flowing in or out through the battery cooling system by the number of flow channels (30);
    the second input unit (220) receives inputs of information associated with the current (I) flowing through the battery cell (BC) and direct current internal resistance (iRcell) of the battery cell (BC), wherein the quantity of heat (Qgen) generated from the battery cell (BC) is calculated as an ohmic heat through the current (I) and the direct current internal resistance (iRcell); the design parameter calculation unit calculates the design parameter through the following equation:

$$m_{cell} C_{p,c} \frac{dT_{cell}}{dt} = q_{gen} - \dot{m}_a C_{p,a} \left( T_{cell} - T_{mi} \right) \left[ 1 - \exp\left( - \frac{PL}{\dot{m}_a C_{p,a}} \overline{h} \right) \right]$$

where

$$\overline{h} = \frac{k_a \overline{Nu_T}}{D_h},$$

$$\overline{Nu_T} = 7.55 + \frac{0.024 L_*^{-1.14}}{1 + 0.0358 \Pr^{0.17} L_*^{-0.64}},$$

$$L_* = \frac{L}{D_h \operatorname{Re} \Pr},$$

$$D_h = \frac{4ab}{P} \approx 2a,$$

$$\operatorname{Re} = \frac{\dot{m}_a D_h}{\mu(ab)}$$

, mcell denotes mass of battery cell, Cp,a denotes specific heat capacity of cooling air, Cp, c denotes specific heat capacity of battery cell, Tcell denotes temperature of battery cell, Qgen denotes quantity of heat generated from battery cell, $\dot{m}_\alpha$ denotes mass flow rate of cooling air passing through each channel, Tmi denotes temperature of inlet, Tmo denotes temperature of outlet, P denotes wetted perimeter of flow channel, a denotes thickness of flow channel, b denotes length of flow channel, L denotes depth of flow channel, $\overline{h}$ denote convective heat transfer coefficient, ka denotes thermal conductivity of cooling air, $\overline{Nu}_T$ denotes Nusselt number averaged over L, L* denotes dimensionless length of flow channel, Pr denotes Prandtl number, Dh denotes hydraulic diameter, Re denotes Reynolds number and μ denotes dynamic viscosity of cooling air.

6. The battery cooling system simulation device according to claim 5, wherein the design parameter is a dimension of the flow channel and a mass flow rate of the cooling air.

7. The battery cooling system simulation device according to claim 6, wherein the dimension of the flow channel includes a thickness, a length, and a depth of the flow channel.

8. The battery cooling system simulation device according to claim 5, wherein the design parameter calculation unit calculates the design parameter through equation approximated as below:

$$\frac{T_{cell} - T_{mi}}{q_{gen}} = \left[ \dot{m}_a C_{p,a} \left( 1 - \exp\left( -\frac{PL}{\dot{m}_a C_{p,a}} \bar{h} \right) \right) \right]^{-1}.$$

9. The battery cooling system simulation device according to claim 5, wherein the design parameter calculation unit calculates the design parameter through equation approximated as below:

$$\frac{T_{cell} - T_{mi}}{q_{gen}} = \left[ \dot{m}_a C_{p,a} \left( 1 - \exp\left( -\frac{PLk_a}{\dot{m}_a C_{p,a} D_h} 7.55 \right) \right) \right]^{-1}.$$

10. The battery cooling system simulation device according to any of claims 5 to 9, further comprising:
    an information storage unit which stores at least one piece of constant or coefficient information.

11. A battery cooling system simulation method that predicts thermal response to a battery cooling system using simulation, the battery cooling system in which cooling air coming in through an inlet (40) goes through at least one flow channel (30) having an approximately rectangular parallelepiped shape having predetermined thickness (a), length (b) and depth (L) and having an aspect ratio (a/b) of the flow channel such that the flow channel can be treated as parallel plate geometry and a wetted perimeter (P) of the flow channel can be approximated to 2b, the at least one flow channel formed along a side wall of at least one battery unit (10) equipped with at least one battery cell (BC) and is discharged through an outlet (50) to cool the battery unit, the battery cooling system simulation method comprising:

   a first input step (S610) for receiving inputs of temperature information of the inlet and temperature information of the outlet;
   a second input step (S620) for receiving inputs of quantity of heat information generated from the battery cell, wherein the second input step (S620) receives inputs of information associated with the current (I) flowing through the battery cell (BC) and direct current internal resistance (iRcell) of the battery cell (BC), wherein the quantity of heat (Qgen) generated from the battery cell (BC) is calculated as an ohmic heat through the current (I) and the direct current internal resistance (iRcell);
   a design parameter input step (S630) for receiving inputs of dimension information of the flow channel and mass flow rate information of the cooling air, wherein the mass flow rate through the at least one flow channel (30) is calculated by dividing the total mass flow rate flowing in or out through the battery cooling system by the number of flow channels (30); and
   a temperature prediction step (S640) for predicting temperature of the battery cell by using the information inputted at the first input step, the second input step, and the design parameter input step,
   wherein the dimension information of the flow channel includes a length, a thickness, and a depth of the flow channel, and
   the temperature prediction step comprises predicting the temperature of the battery cell through the following equation:

$$m_{cell} C_{p,c} \frac{dT_{cell}}{dt} = q_{gen} - \dot{m}_a C_{p,a} \left( T_{cell} - T_{mi} \right) \left[ 1 - \exp\left( -\frac{PL}{\dot{m}_a C_{p,a}} \bar{h} \right) \right]$$

   where

$$\overline{h} = \frac{k_a \overline{Nu}_T}{D_h} \quad ,$$

$$\overline{Nu}_T = 7.55 + \frac{0.024 L_*^{-1.14}}{1 + 0.0358 \, \mathrm{Pr}^{0.17} \, L_*^{-0.64}} \quad ,$$

$$L_* = \frac{L}{D_h \, \mathrm{Re} \, \mathrm{Pr}} \quad ,$$

$$D_h = \frac{4ab}{P} \approx 2a \quad ,$$

$$\mathrm{Re} = \frac{\dot{m}_a D_h}{\mu(ab)}$$

, mcell denotes mass of battery cell, Cp,a denotes specific heat capacity of cooling air, Cp, c denotes specific heat capacity of battery cell, Tcell denotes temperature of battery cell, Qgen denotes quantity of heat generated from battery cell, $\dot{m}_\alpha$ denotes mass flow rate of cooling air passing through each channel, Tmi denotes temperature of inlet, Tmo denotes temperature of outlet, P denotes wetted perimeter of flow channel, a denotes thickness of flow channel, b denotes length of flow channel, L denotes depth of flow channel, $\overline{h}$ denote convective heat transfer coefficient, ka denotes thermal conductivity of cooling air, $\overline{Nu}_T$ denotes Nusselt number averaged over L, L* denotes dimensionless length of flow channel, Pr denotes Prandtl number, Dh denotes hydraulic diameter, Re denotes Reynolds number and $\mu$ denotes dynamic viscosity of cooling air.

## Patentansprüche

1. Batteriekühlsystem-Simulationsvorrichtung, welche eine Temperatur einer Batteriezelle, welche einem Batteriekühlsystem ausgesetzt wird, unter Verwendung einer Simulation vorhersagt, wobei in dem Batteriekühlsystem Kühlluft, welche durch einen Einlass (40) einströmt, durch wenigstens einen Strömungskanal (30) verläuft, welcher eine im Wesentlichen rechteckige parallelepipede Form mit einer vorbestimmten Dicke (a), Länge (b) und Tiefe (L) und mit einem Aspektverhältnis (a/b) des Strömungskanals derart aufweist, dass der Strömungskanal als parallele Plattengeometrie behandelt werden kann und ein befeuchteter Umfang (P) des Strömungskanals auf 2b angenähert werden kann, wobei der wenigstens eine Strömungskanal entlang einer Seitenwand der wenigstens einen Batterieeinheit (10) gebildet ist, welche mit wenigstens einer Batteriezelle (BC) ausgestattet ist, und durch einen Auslass (50) abgegeben wird, um die Batterieeinheit zu kühlen, wobei die Batteriekühlsystem-Simulationsvorrichtung umfasst:

eine erste Eingabeeinheit (110), welche Eingaben von Temperaturinformationen (Tmi) des Einlasses (40) und Temperaturinformationen (Tmo) des Auslasses (50) empfängt;
eine zweite Eingabeeinheit (120), welche Eingaben von Informationen über eine Wärmemenge (Qgen) empfängt, welche von der Batteriezelle (BC) erzeugt wird;
eine Designparameter-Eingabeeinheit (130), welche Eingaben von Dimensionsinformationen des Strömungskanals und Massenstromraten-Informationen der Kühlluft empfängt; und
eine Temperatur-Vorhersageeinheit (140), welche eine Temperatur der Batteriezelle unter Verwendung der Informationen vorhersagt, welche von der ersten Eingabeeinheit, der zweiten Eingabeeinheit und der Designparameter-Eingabeeinheit eingegeben worden sind,
wobei
die Massenstromrate durch den wenigstens einen Strömungskanal (30) durch Teilen der gesamten Massenstromrate, welche durch das Batteriekühlsystem herein oder heraus strömt, durch die Anzahl von Strömungskanälen (30) berechnet wird;

die zweite Eingabeeinheit (120) Eingaben von Informationen empfängt, welche dem Strom (I), welcher durch die Batteriezelle (BC) strömt, und einem internen Gleichstromwiderstand (iRcell) der Batteriezelle (BC) zugeordnet sind, wobei die Wärmemenge (Qgen), welche von der Batteriezelle (BC) erzeugt wird, als eine ohmsche Wärme durch den Strom (I) und den internen Gleichstromwiderstand (iRcell) berechnet wird; wobei die Dimensionsinformationen des Strömungskanals eine Länge, eine Dicke und eine Tiefe des Strömungskanals umfassen, und die Temperatur-Vorhersageeinheit die Temperatur der Batteriezelle durch die folgende Gleichung vorhersagt:

$$m_{cell} C_{p,c} \frac{dT_{cell}}{dt} = q_{gen} - \dot{m}_a C_{p,a} \left( T_{cell} - T_{mi} \right) \left[ 1 - \exp\left( -\frac{PL}{\dot{m}_a C_{p,a}} \overline{h} \right) \right]$$

wobei

$$\overline{h} = \frac{k_a \overline{Nu_T}}{D_h} \quad,$$

$$\overline{Nu_T} = 7.55 + \frac{0.024 L_*^{-1.14}}{1 + 0.0358 \, \mathrm{Pr}^{0.17} \, L_*^{-0.64}} \quad,$$

$$L_* = \frac{L}{D_h \, \mathrm{Re} \, \mathrm{Pr}} \quad,$$

$$D_h = \frac{4ab}{P} \approx 2a \quad,$$

$$\mathrm{Re} = \frac{\dot{m}_a D_h}{\mu(ab)} \quad,$$

mcell eine Masse einer Batteriezelle bezeichnet, Cp,a eine spezifische Wärmekapazität von Kühlluft bezeichnet, Cp,c eine spezifische Wärmekapazität einer Batteriezelle bezeichnet, Tcell eine Temperatur einer Batteriezelle bezeichnet, Qgen eine Wärmemenge bezeichnet, welche von einer Batteriezelle erzeugt wird, $\dot{m}_\alpha$ eine . Massenstromrate von Kühlluft bezeichnet, welche durch jeden Kanal durchtritt, Tmi eine Temperatur eines Einlasses bezeichnet, Tmo eine Temperatur eines Auslasses bezeichnet, P einen befeuchteten Umfang eines Strömungskanals bezeichnet, a eine Dicke eines Strömungskanals bezeichnet, b eine Länge eines Strömungskanals bezeichnet, L eine Tiefe eines Strömungskanals bezeichnet, $\overline{h}$ einen kovektiven Wärmetransferkoeffizienten bezeichnet, ka eine Wärmeleitfähigkeit von Kühlluft bezeichnet, $\overline{Nu_T}$ eine Nusselt-Zahl bezeichnet, welche über L gemittelt wird, L* eine dimensionslose Länge eines Strömungskanals bezeichnet, Pr eine Prandtl-Zahl bezeichnet, Dh einen hydraulischen Durchmesser bezeichnet, Re eine Reynolds-Zahl bezeichnet und μ eine dynamische Viskosität von Kühlluft bezeichnet.

2. Batteriekühlsystem-Simulationsvorrichtung nach Anspruch 1, wobei die Temperatur-Vorhersageeinheit die Temperatur der Batteriezelle durch eine Gleichung vorhersagt, welche wie nachfolgend angenähert wird:

$$\frac{T_{cell} - T_{mi}}{q_{gen}} = \left[ \dot{m}_a C_{p,a} \left( 1 - \exp\left( - \frac{PL}{\dot{m}_a C_{p,a}} \overline{h} \right) \right) \right]^{-1} .$$

3. Batteriekühlsystem-Simulationsvorrichtung nach Anspruch 1, wobei die Temperatur-Vorhersageeinheit die Temperatur der Batteriezelle durch eine Gleichung vorhersagt, welche wie nachfolgend angenähert wird:

$$\frac{T_{cell} - T_{mi}}{q_{gen}} = \left[ \dot{m}_a C_{p,a} \left( 1 - \exp\left( - \frac{PLk_a}{\dot{m}_a C_{p,a} D_h} 7.55 \right) \right) \right]^{-1} .$$

4. Batteriekühlsystem-Simulationsvorrichtung nach einem der Ansprüche 1 bis 3, ferner umfassend:
eine Informations-Speichereinheit, welche wenigstens ein Stück von Konstanten- oder Koeffizienten-Informationen speichert.

5. Batteriekühlsystem-Simulationsvorrichtung, welche einen Designparameter eines Batteriekühlsystems unter Verwendung einer Simulation berechnet, wobei in dem Batteriekühlsystem Kühlluft, welche durch einen Einlass (40) einströmt, durch wenigstens einen Strömungskanal (30) verläuft, welcher eine im Wesentlichen rechteckige parallelepipede Form mit einer vorbestimmten Dicke (a), Länge (b) und Tiefe (L) und mit einem Aspektverhältnis (a/b) des Strömungskanals derart aufweist, dass der Strömungskanal als parallele Plattengeometrie behandelt werden kann und ein befeuchteter Umfang (P) des Strömungskanals auf 2b angenähert werden kann, wobei der wenigstens eine Strömungskanal entlang einer Seitenwand der wenigstens einen Batterieeinheit (10) gebildet ist, welche mit wenigstens einer Batteriezelle (BC) ausgestattet ist, und durch einen Auslass (50) abgegeben wird, um die Batterieeinheit zu kühlen, wobei die Batteriekühlsystem-Simulationsvorrichtung umfasst:

eine erste Eingabeeinheit (210), welche Eingaben von Temperaturinformationen des Einlasses und Temperaturinformationen des Auslasses empfängt;
eine zweite Eingabeeinheit (220), welche Eingaben von Informationen über eine Wärmemenge (Qgen) empfängt, welche von der Batteriezelle erzeugt wird;
eine Temperatur-Eingabeeinheit (230), welche Eingaben von Zieltemperatur-Informationen empfängt; und
eine Designparameter-Berechnungseinheit (240), welche einen Designparameter, welcher es der Temperatur der Batteriezelle erlaubt, die Zieltemperatur zu erfüllen, unter Verwendung der Informationen berechnet, welche von der ersten Eingabeeinheit, der zweiten Eingabeeinheit und der Temperatur-Eingabeeinheit eingegeben worden sind,
wobei
die Massenstromrate durch den wenigstens einen Strömungskanal (30) durch Teilen der gesamten Massenstromrate, welche durch das Batteriekühlsystem herein oder heraus strömt, durch die Anzahl von Strömungskanälen (30) berechnet wird;
die zweite Eingabeeinheit (220) Eingaben von Informationen empfängt, welche dem Strom (I), welcher durch
die Batteriezelle (BC) strömt, und einem internen Gleichstromwiderstand (iRcell) der Batteriezelle (BC) zugeordnet sind, wobei die Wärmemenge (Qgen), welche von der Batteriezelle (BC) erzeugt wird, als eine ohmsche
Wärme durch den Strom (I) und den internen Gleichstromwiderstand (iRcell) berechnet wird; wobei die Designparameter-Berechnungseinheit den Designparameter durch die folgende Gleichung berechnet:

$$m_{cell} C_{p,c} \frac{dT_{cell}}{dt} = q_{gen} - \dot{m}_a C_{p,a} \left( T_{cell} - T_{mi} \right) \left[ 1 - \exp\left( - \frac{PL}{\dot{m}_a C_{p,a}} \overline{h} \right) \right]$$

wobei

$$\overline{h} = \frac{k_a \overline{Nu_T}}{D_h},$$

$$\overline{Nu_T} = 7.55 + \frac{0.024 L_*^{-1.14}}{1 + 0.0358 \mathrm{Pr}^{0.17} L_*^{-0.64}},$$

$$L_* = \frac{L}{D_h \mathrm{Re} \mathrm{Pr}},$$

$$D_h = \frac{4ab}{P} \approx 2a,$$

$$\mathrm{Re} = \frac{\dot{m}_a D_h}{\mu(ab)},$$

mcell eine Masse einer Batteriezelle bezeichnet, Cp,a eine spezifische Wärmekapazität von Kühlluft bezeichnet,
Cp,c eine spezifische Wärmekapazität einer Batteriezelle bezeichnet, Tcell eine Temperatur einer Batteriezelle bezeichnet, Qgen eine Wärmemenge bezeichnet, welche von einer Batteriezelle erzeugt wird, $\dot{m}_\alpha$ eine Massenstromrate von Kühlluft bezeichnet, welche durch jeden Kanal durchtritt, Tmi eine Temperatur eines Einlasses bezeichnet, Tmo eine Temperatur eines Auslasses bezeichnet, P einen befeuchteten Umfang eines Strömungskanals bezeichnet, a eine Dicke eines Strömungskanals bezeichnet, b eine Länge eines Strömungskanals bezeichnet, L eine Tiefe eines Strömungskanals bezeichnet, $\bar{h}$ einen kovektiven Wärmetransferkoeffizienten bezeichnet, ka eine Wärmeleitfähigkeit von Kühlluft bezeichnet, $\overline{Nu_T}$ eine Nusselt-Zahl bezeichnet, welche über L gemittelt wird, L* eine dimensionslose Länge eines Strömungskanals bezeichnet, Pr eine Prandtl-Zahl bezeichnet, Dh einen hydraulischen Durchmesser bezeichnet, Re eine Reynolds-Zahl bezeichnet und μ eine dynamische Viskosität von Kühlluft bezeichnet.

6. Batteriekühlsystem-Simulationsvorrichtung nach Anspruch 5, wobei der Designparameter eine Dimension des Strömungskanals und eine Massenstromrate der Kühlluft ist.

7. Batteriekühlsystem-Simulationsvorrichtung nach Anspruch 6, wobei die Dimension des Strömungskanals eine Dicke, eine Länge und eine Tiefe des Strömungskanals umfasst.

8. Batteriekühlsystem-Simulationsvorrichtung nach Anspruch 5, wobei die Designparameter-Berechnungseinheit den Designparameter durch eine Gleichung berechnet, welche wie nachfolgend angenähert wird:

$$\frac{T_{cell} - T_{mi}}{q_{gen}} = \left[ \dot{m}_a C_{p,a} \left( 1 - \exp\left( -\frac{PL}{\dot{m}_a C_{p,a}} \bar{h} \right) \right) \right]^{-1}.$$

9. Batteriekühlsystem-Simulationsvorrichtung nach Anspruch 5, wobei die Designparameter-Berechnungseinheit den Designparameter durch eine Gleichung berechnet, welche wie nachfolgend angenähert wird:

$$\frac{T_{cell} - T_{mi}}{q_{gen}} = \left[ \dot{m}_a C_{p,a} \left( 1 - \exp\left( -\frac{PLk_a}{\dot{m}_a C_{p,a} D_h} 7.55 \right) \right) \right]^{-1}.$$

10. Batteriekühlsystem-Simulationsvorrichtung nach einem der Ansprüche 5 bis 9, ferner umfassend:
eine Informations-Speichereinheit, welche wenigstens ein Stück von Konstanten- oder Koeffizienten-Informationen speichert.

11. Batteriekühlsystem-Simulationsverfahren, welches eine thermische Reaktion auf ein Batteriekühlsystem unter Verwendung einer Simulation vorhersagt, wobei in dem Batteriekühlsystem Kühlluft, welche durch einen Einlass (40) einströmt, durch wenigstens einen Strömungskanal (30) verläuft, welcher eine im Wesentlichen rechteckige parallelepipede Form mit einer vorbestimmten Dicke (a), Länge (b) und Tiefe (L) und mit einem Aspektverhältnis (a/b) des Strömungskanals derart aufweist, dass der Strömungskanal als parallele Plattengeometrie behandelt werden kann und ein befeuchteter Umfang (P) des Strömungskanals auf 2b angenähert werden kann, wobei der wenigstens eine Strömungskanal entlang einer Seitenwand der wenigstens einen Batterieeinheit (10) gebildet ist, welche mit wenigstens einer Batteriezelle (BC) ausgestattet ist, und durch einen Auslass (50) abgegeben wird, um die Batterieeinheit zu kühlen, wobei das Batteriekühlsystem-Simulationsverfahren umfasst:

einen ersten Eingabeschritt (S610), um Eingaben von Temperaturinformationen des Einlasses und Temperaturinformationen des Auslasses zu empfangen;
einen zweiten Eingabeschritt (S620), um Eingaben von Informationen über eine Wärmemenge zu empfangen, welche von der Batteriezelle erzeugt wird, wobei der zweite Eingabeschritt (S620) Eingaben von Informationen empfängt, welche dem Strom (I), welcher durch die Batteriezelle (BC) strömt, und einem internen Gleichstromwiderstand (iRcell) der Batteriezelle (BC) zugeordnet sind, wobei die Wärmemenge (Qgen), welche von der Batteriezelle (BC) erzeugt wird, als eine ohmsche Wärme durch den Strom (I) und den internen Gleichstromwiderstand (iRcell) berechnet wird;

einen Designparameter-Eingabeschritt (S630), um Eingaben von Dimensionsinformationen des Strömungskanals und Massenstromraten-Informationen der Kühlluft zu empfangen, wobei die Massenstromrate durch den wenigstens einen Strömungskanal (30) durch Teilen der gesamten Massenstromrate, welche durch das Batteriekühlsystem herein oder heraus strömt, durch die Anzahl von Strömungskanälen (30) berechnet wird; und

einen Temperatur-Vorhersageschritt (S640), um eine Temperatur der Batteriezelle unter Verwendung der Informationen vorherzusagen, welche bei dem ersten Eingabeschritt, dem zweiten Eingabeschritt und dem Designparameter-Eingabeschritt eingegeben worden sind, wobei die Dimensionsinformationen des Strömungskanals eine Länge, eine Dicke und eine Tiefe des Strömungskanals umfassen, und der Temperatur-Vorhersageschritt die Temperatur der Batteriezelle durch die folgende Gleichung vorhersagt:

$$m_{cell} C_{p,c} \frac{dT_{cell}}{dt} = q_{gen} - \dot{m}_a C_{p,a} \left( T_{cell} - T_{mi} \right) \left[ 1 - \exp \left( - \frac{PL}{\dot{m}_a C_{p,a}} \overline{h} \right) \right]$$

wobei

$$\overline{h} = \frac{k_a \overline{Nu_T}}{D_h} ,$$

$$\overline{Nu_T} = 7.55 + \frac{0.024 L_*^{-1.14}}{1 + 0.0358 \mathrm{Pr}^{0.17} L_*^{-0.64}} ,$$

$$L_* = \frac{L}{D_h \, \mathrm{Re} \, \mathrm{Pr}} ,$$

$$D_h = \frac{4ab}{P} \approx 2a ,$$

$$\mathrm{Re} = \frac{\dot{m}_a D_h}{\mu(ab)} ,$$

mcell eine Masse einer Batteriezelle bezeichnet, Cp,a eine spezifische Wärmekapazität von Kühlluft bezeichnet, Cp,c eine spezifische Wärmekapazität einer Batteriezelle bezeichnet, Tcell eine Temperatur einer Batteriezelle bezeichnet, Qgen eine Wärmemenge bezeichnet, welche von einer Batteriezelle erzeugt wird, $\dot{m}_a$ eine Massenstromrate von Kühlluft bezeichnet, welche durch jeden Kanal durchtritt, Tmi eine Temperatur eines Einlasses bezeichnet, Tmo eine Temperatur eines Auslasses bezeichnet, P einen befeuchteten Umfang eines Strömungskanals bezeichnet, a eine Dicke eines Strömungskanals bezeichnet, b eine Länge eines Strömungskanals bezeichnet, L eine Tiefe eines Strömungskanals bezeichnet, $\bar{h}$ einen kovektiven Wärmetransferkoeffizienten bezeichnet, ka eine Wärmeleitfähigkeit von Kühlluft bezeichnet, $\overline{Nu}_T$ eine Nusselt-Zahl bezeichnet, welche über L gemittelt wird, L* eine dimensionslose Länge eines Strömungskanals bezeichnet, Pr eine Prandtl-Zahl bezeichnet, Dh einen hydraulischen Durchmesser bezeichnet, Re eine Reynolds-Zahl bezeichnet und μ eine dynamische Viskosität von Kühlluft bezeichnet.

## Revendications

1.  Dispositif de simulation de système de refroidissement de batterie qui prédit une température d'un élément de batterie soumis à un système de refroidissement de batterie utilisant une simulation, le système de refroidissement de batterie dans lequel de l'air de refroidissement entrant à travers une admission (40) traverse au moins un canal d'écoulement (30) ayant une forme de parallélépipède approximativement rectangulaire ayant une épaisseur (a), une longueur (b) et une profondeur (L) prédéterminées et ayant un rapport de côté (a/b) du canal d'écoulement tel que le canal d'écoulement peut être traité en tant que géométrie de plaques parallèles et un périmètre mouillé (P) du canal d'écoulement peut être approximé par 2b, l'au moins un canal d'écoulement étant formé le long d'une paroi latérale d'au moins une unité de batterie (10) équipée d'au moins un élément de batterie (BC) et est déchargé à travers un refoulement (50) pour refroidir l'unité de batterie, le dispositif de simulation de système de refroidissement de batterie comprenant :

    une première unité d'entrée (110) qui reçoit des entrées d'informations de température (Tmi) de l'admission (40) et d'informations de température (Tmo) du refoulement (50) ;
    une seconde unité d'entrée (120) qui reçoit des entrées d'informations de quantité de chaleur (Qgen) générée par l'élément de batterie (BC) ;
    une unité d'entrée de paramètre de conception (130) qui reçoit des entrées d'informations de dimension du canal d'écoulement et d'informations de débit massique de l'air de refroidissement ; et
    une unité de prédiction de température (140) qui prédit une température de l'élément de batterie en utilisant les informations fournies en entrée par la première unité d'entrée, la seconde unité d'entrée, et l'unité d'entrée de paramètre de conception, dans lequel
    le débit massique à travers l'au moins un canal d'écoulement (30) est calculé en divisant le débit massique total entrant à l'intérieur ou sortant du système de refroidissement de batterie par le nombre de canaux d'écoulement (30) ;
    la seconde unité d'entrée (120) reçoit des entrées d'informations associées au courant (I) s'écoulant à travers l'élément de batterie (BC) et une résistance interne à courant continu (iRCell) de l'élément de batterie (BC), dans lequel la quantité de chaleur (Qgen) générée par l'élément de batterie (BC) est calculée en tant que chaleur ohmique à travers le courant (I) et la résistance interne à courant continu (iRCell) ; les informations de dimension du canal d'écoulement incluent une longueur, une épaisseur, et une profondeur du canal d'écoulement, et l'unité de prédiction de température prédit la température de l'élément de batterie par l'équation suivante :

$$m_{cell}C_{p,c}\frac{dT_{cell}}{dt} = q_{gen} - \dot{m}_a C_{p,a}\left(T_{cell} - T_{mi}\right)\left[1 - \exp\left(-\frac{PL}{\dot{m}_a C_{p,a}}\bar{h}\right)\right]$$

où

$$\bar{h} = \frac{k_a \overline{Nu}_T}{D_h},$$

$$\overline{Nu}_T = 7,55 + \frac{0,024 L_*^{-1,14}}{1 + 0,0358 \mathrm{Pr}^{0.17} L_*^{-0,64}} \quad ,$$

$$L_* = \frac{L}{D_h \, \mathrm{Re} \, \mathrm{Pr}} \quad ,$$

$$D_h = \frac{4ab}{P} \approx 2a \quad ,$$

$$\mathrm{Re} = \frac{\dot{m}_a D_h}{\mu(ab)}$$

, , mCell désigne la masse de l'élément de batterie, Cp,a désigne la capacité de chaleur spécifique de l'air de refroidissement, Cp,c désigne la capacité de chaleur spécifique de l'élément de batterie, TCell désigne la température de l'élément de batterie, Qgen désigne la quantité de chaleur générée par l'élément de batterie, $\dot{m}_a$ désigne le débit massique de l'air de refroidissement passant à travers chaque canal, Tmi désigne la température d'admission, Tmo désigne la température de refoulement, P désigne le périmètre mouillé du canal d'écoulement, a désigne l'épaisseur du canal d'écoulement, b désigne la longueur du canal d'écoulement, L désigne la profondeur du canal d'écoulement, $\overline{h}$ désigne le coefficient de transfert de chaleur par convection, ka désigne la conductivité thermique de l'air de refroidissement, $\overline{Nu}_T$ désigne le nombre de Nusselt moyenné sur L, L* désigne la longueur sans dimension du canal d'écoulement, Pr désigne le nombre de Prandtl, Dh désigne le diamètre hydraulique, Re désigne le nombre de Reynolds et $\mu$ désigne la viscosité dynamique de l'air de refroidissement.

2. Dispositif de simulation de système de refroidissement de batterie selon la revendication 1, dans lequel l'unité de prédiction de température prédit la température de l'élément de batterie par l'équation approximée comme ci-après :

$$\frac{T_{cell} - T_{mi}}{q_{gen}} = \left[ \dot{m}_a C_{p,a} \left( 1 - \exp\left( -\frac{PL}{\dot{m}_a C_{p,a}} \overline{h} \right) \right) \right]^{-1} .$$

3. Dispositif de simulation de système de refroidissement de batterie selon la revendication 1, dans lequel l'unité de prédiction de température prédit la température de l'élément de batterie par l'équation approximée comme ci-après :

$$\frac{T_{cell} - T_{mi}}{q_{gen}} = \left[ \dot{m}_a C_{p,a} \left( 1 - \exp\left( -\frac{PLk_a}{\dot{m}_a C_{p,a} D_h} 7.55 \right) \right) \right]^{-1} .$$

4. Dispositif de simulation de système de refroidissement de batterie selon l'une quelconque des revendications 1 à 3, comprenant en outre :
une unité de stockage d'informations qui stocke au moins une information de constante ou de coefficient.

5. Dispositif de simulation de système de refroidissement de batterie qui calcule un paramètre de conception d'un système de refroidissement de batterie utilisant une simulation, le système de refroidissement de batterie dans lequel de l'air de refroidissement entrant à travers une admission (40) traverse au moins un canal d'écoulement (30) ayant une forme de parallélépipède approximativement rectangulaire ayant une épaisseur (a), une longueur (b) et une profondeur (L) prédéterminées et ayant un rapport de côté (a/b) du canal d'écoulement tel que le canal d'écoulement peut être traité en tant que géométrie de plaques parallèles et un périmètre mouillé (P) du canal d'écoulement peut être approximé par 2b, l'au moins un canal d'écoulement étant formé le long d'une paroi latérale d'au moins une unité de batterie (10) équipée d'au moins un élément de batterie (BC) et est déchargé à travers un refoulement (50) pour refroidir l'unité de batterie, le dispositif de simulation de système de refroidissement de batterie comprenant :

une première unité d'entrée (210) qui reçoit des entrées d'informations de température de l'admission et d'informations de température du refoulement ;
une seconde unité d'entrée (220) qui reçoit des entrées d'informations de quantité de chaleur (Qgen) générée par l'élément de batterie ;
une unité d'entrée de température (230) qui reçoit des entrées d'informations de température cible ; et
une unité de calcul de paramètre de conception (240) qui calcule un paramètre de conception permettant à la température de l'élément de batterie de satisfaire la température cible en utilisant les informations fournies en entrée par la première unité d'entrée, la seconde unité d'entrée, et l'unité d'entrée de température,
dans lequel
le débit massique à travers l'au moins un canal d'écoulement (30) est calculé en divisant le débit massique total entrant à l'intérieur ou sortant du système de refroidissement de batterie par le nombre de canaux d'écoulement (30) ;
la seconde unité d'entrée (220) reçoit des entrées d'informations associées au courant (I) s'écoulant à travers l'élément de batterie (BC) et une résistance interne à courant continu (iRCell) de l'élément de batterie (BC), dans lequel la quantité de chaleur (Qgen) générée par l'élément de batterie (BC) est calculée en tant que chaleur ohmique à travers le courant (I) et la résistance interne à courant continu (iRCell) ; l'unité de calcul de paramètre de conception calcule le paramètre de conception par l'équation suivante :

$$m_{cell} C_{p,c} \frac{dT_{cell}}{dt} = q_{gen} - \dot{m}_a C_{p,a} \left( T_{cell} - T_{mi} \right) \left[ 1 - \exp\left( - \frac{PL}{\dot{m}_a C_{p,a}} \overline{h} \right) \right]$$

où

$$\overline{h} = \frac{k_a \overline{Nu_T}}{D_h} \, ,$$

$$\overline{Nu_T} = 7,55 + \frac{0,024 L_*^{-1,14}}{1 + 0,0358 \, \mathrm{Pr}^{0,17} \, L_*^{-0,64}} \, ,$$

$$L_* = \frac{L}{D_h \, \mathrm{Re} \, \mathrm{Pr}} \, ,$$

$$D_h = \frac{4ab}{P} \approx 2a \, ,$$

$$\mathrm{Re} = \frac{\dot{m}_a D_h}{\mu(ab)}$$

, mCell désigne la masse de l'élément de batterie, Cp,a désigne la capacité de chaleur spécifique de l'air de refroidissement, Cp,c désigne la capacité de chaleur spécifique de l'élément de batterie, TCell désigne la température de l'élément de batterie, Qgen désigne la quantité de chaleur générée par l'élément de batterie, $\dot{m}_a$ désigne le débit massique de l'air de refroidissement passant à travers chaque canal, Tmi désigne la température d'admission, Tmo désigne la température de refoulement, P désigne le périmètre mouillé du canal d'écoulement, a désigne l'épaisseur du canal d'écoulement, b désigne la longueur du canal d'écoulement, L désigne la profondeur du canal d'écoulement, $\bar{h}$ désigne le coefficient de transfert de chaleur par convection, ka désigne la conductivité thermique de l'air de refroidissement, $\overline{Nu}_T$ désigne le nombre de Nusselt moyenné sur L, L* désigne la longueur sans dimension du canal d'écoulement, Pr désigne le nombre de Prandtl, Dh désigne le diamètre hydraulique, Re désigne le nombre de Reynolds et µ désigne la viscosité dynamique de l'air de refroidissement.

6. Dispositif de simulation de système de refroidissement de batterie selon la revendication 5, dans lequel le paramètre de conception est une dimension du canal d'écoulement et un débit massique de l'air de refroidissement.

7. Dispositif de simulation de système de refroidissement de batterie selon la revendication 6, dans lequel la dimension du canal d'écoulement inclut une épaisseur, une longueur, et une profondeur du canal d'écoulement.

8. Dispositif de simulation de système de refroidissement de batterie selon la revendication 5, dans lequel l'unité de calcul de paramètre de conception calcule le paramètre de conception par l'équation approximée comme ci-après :

$$\frac{T_{cell} - T_{mi}}{q_{gen}} = \left[ \dot{m}_a C_{p,a} \left( 1 - \exp\left( - \frac{PL}{\dot{m}_a C_{p,a}} \bar{h} \right) \right) \right]^{-1}.$$

9. Dispositif de simulation de système de refroidissement de batterie selon la revendication 5, dans lequel l'unité de calcul de paramètre de conception calcule le paramètre de conception par l'équation approximée comme ci-après :

$$\frac{T_{cell} - T_{mi}}{q_{gen}} = \left[ \dot{m}_a C_{p,a} \left( 1 - \exp\left( - \frac{PLk_a}{\dot{m}_a C_{p,a} D_h} 7.55 \right) \right) \right]^{-1}.$$

10. Dispositif de simulation de système de refroidissement de batterie selon l'une quelconque des revendications 5 à 9, comprenant en outre :
une unité de stockage d'informations qui stocke au moins une information de constante ou de coefficient.

11. Procédé de simulation de système de refroidissement de batterie qui prédit une réponse thermique à un système de refroidissement de batterie utilisant une simulation, le système de refroidissement de batterie dans lequel de l'air entrant à travers une admission (40) traverse au moins un canal d'écoulement (30) ayant une forme de parallélépipède approximativement rectangulaire ayant une épaisseur (a), une longueur (b) et une profondeur (L) prédéterminées et ayant un rapport de côté (a/b) du canal d'écoulement tel que le canal d'écoulement peut être traité en tant que géométrie de plaques parallèles et un périmètre mouillé (P) du canal d'écoulement peut être approximé par 2b, l'au moins un canal d'écoulement étant formé le long d'une paroi latérale d'au moins une unité de batterie (10) équipée d'au moins un élément de batterie (BC) et est déchargé à travers un refoulement (50) pour refroidir l'unité de batterie, le procédé de simulation de système de refroidissement de batterie comprenant :

une première étape d'entrée (S610) pour recevoir des entrées d'informations de température de l'admission et d'informations de température du refoulement ;

une seconde étape d'entrée (S620) pour recevoir des entrées d'informations de quantité de chaleur générée par l'élément de batterie, dans lequel la seconde étape d'entrée (S620) reçoit des entrées d'informations associées au courant (I) s'écoulant à travers l'élément de batterie (BC) et une résistance interne à courant continu (iRCell) de l'élément de batterie (BC), dans lequel la quantité de chaleur (Qgen) générée par l'élément de batterie (BC) est calculée en tant que chaleur ohmique à travers le courant (I) et la résistance interne à courant continu (iRCell) ;

une étape d'entrée de paramètre de conception (S630) pour recevoir des entrées d'informations de dimension du canal d'écoulement et d'informations de débit massique de l'air de refroidissement, dans lequel le débit massique à travers l'au moins un canal d'écoulement (30) est calculé en divisant le débit massique total entrant à l'intérieur ou sortant du système de refroidissement de batterie par le nombre de canaux d'écoulement (30) ; et

une étape de prédiction de température (S640) pour prédire une température de l'élément de batterie en utilisant les informations fournies en entrée dans la première étape d'entrée, la seconde étape d'entrée, et l'étape d'entrée de paramètre de conception,

dans lequel les informations de dimension du canal d'écoulement incluent une longueur, une épaisseur, et une profondeur du canal d'écoulement, et

l'étape de prédiction de température comprend la prédiction de la température de l'élément de batterie par l'équation suivante :

$$m_{cell} C_{p,c} \frac{dT_{cell}}{dt} = q_{gen} - \dot{m}_a C_{p,a} \left( T_{cell} - T_{mi} \right) \left[ 1 - \exp\left( - \frac{PL}{\dot{m}_a C_{p,a}} \overline{h} \right) \right]$$

où

$$\overline{h} = \frac{k_a \overline{Nu}_T}{D_h},$$

$$\overline{Nu}_T = 7{,}55 + \frac{0{,}024 L_*^{-1{,}14}}{1 + 0{,}0358 \mathrm{Pr}^{0.17} L_*^{-0{,}64}},$$

$$L_* = \frac{L}{D_h \mathrm{Re}\, \mathrm{Pr}},$$

$$D_h = \frac{4ab}{P} \approx 2a,$$

$$\mathrm{Re} = \frac{\dot{m}_a D_h}{\mu (ab)}$$

, mCell désigne la masse de l'élément de batterie, Cp,a désigne la capacité de chaleur spécifique de l'air de refroidissement, Cp,c désigne la capacité de chaleur spécifique de l'élément de batterie, TCell désigne la température de l'élément de batterie, Qgen désigne la quantité de chaleur générée par l'élément de batterie, $\dot{m}_a$ désigne le débit massique de l'air de refroidissement passant à travers chaque canal, Tmi désigne la température d'admission, Tmo désigne la température de refoulement, P désigne le périmètre mouillé du canal d'écoulement, a désigne l'épaisseur du canal d'écoulement, b désigne la longueur du canal d'écoulement, L désigne la profondeur du canal d'écoulement, $\overline{h}$ désigne le coefficient de transfert de chaleur par convection, ka désigne la conductivité thermique de l'air de refroidissement, $\overline{Nu}_T$ désigne le nombre de Nusselt moyenné sur L, L* désigne la longueur sans dimension du canal d'écoulement, Pr désigne le nombre de Prandtl, Dh désigne le diamètre hydraulique, Re désigne le nombre de Reynolds et μ désigne la viscosité dynamique de l'air de refroidissement.

## FIG. 1

# FIG. 2

**FIG. 3**

## FIG. 4

| | |
|---|---|
| FIRST INPUT UNIT | 110 |
| SECOND INPUT UNIT | 120 |
| DESIGN PARAMETER INPUT UNIT | 130 |
| TEMPERATURE PREDICTION UNIT | 140 |

# FIG. 5

| FIRST INPUT UNIT | 210 |
| SECOND INPUT UNIT | 220 |
| TEMPERATURE INPUT UNIT | 230 |
| DESIGN PARAMETER CALCULATION UNIT | 240 |

# FIG. 6

INPUT INLET TEMPERATURE AND
OUTLET TEMPERATURE INFORMATION ~S610

INPUT AMOUNT OF HEAT GENERATED
$(Q_{gen})$ INFORMATION ~S620

INPUT DIMENSION INFORMATION OF FLOW CHANNEL
AND MASS FLOW RATE INFORMATION OF COOLING AIR ~S630

PREDICT TEMPERATURE OF BATTERY CELL ~S640

## FIG. 7

```
┌────────────────────────────────────────┐
│       INPUT INLET TEMPERATURE AND       │ ~S710
│     OUTLET TEMPERATURE INFORMATION      │
└────────────────────────────────────────┘
                    │
                    ▼
┌────────────────────────────────────────┐
│     INPUT AMOUNT OF HEAT GENERATED      │ ~S720
│         (Q_{gen}) INFORMATION           │
└────────────────────────────────────────┘
                    │
                    ▼
┌────────────────────────────────────────┐
│     INPUT TARGET TEMPERATURE INFORMATION│ ~S730
└────────────────────────────────────────┘
                    │
                    ▼
┌────────────────────────────────────────┐
│        CALCULATE DESIGN PARAMETER       │ ~S740
└────────────────────────────────────────┘
```

**EP 3 136 496 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020140058995

### Non-patent literature cited in the description

- Journal of power sources. Elsevier SA, 27 March 2013, vol. 239
- *Journal of power sources,* 01 February 2013, vol. 223
- **INCROPERA,F.P. ; DEWITT,D.P.** Fundamentals of Heat and Mass Transfer. John Wiley & Sons, 1996
- **SHAH, R.K. ; LONDON, A.L.** Laminar Flow Forced Convection in Ducts. Academic Press, 1978